# EUROPEAN PATENT SPECIFICATION

(11) **EP 2 924 506 B1**
(45) Date of publication and mention of the grant of the patent: **26.10.2016**
(21) Application number: 15160410.5
(22) Date of filing: 23.03.2015
(51) Int. Cl.: G03F 7/20, C04B 35/00, C04B 35/563, C04B 35/573, C04B 35/626, C04B 35/63

(54) **Reaction sintered silicon carbide member**
Reaktionsgesintertes siliciumkarbidglied
Élément en carbure de silicium fritté par réaction

(30) Priority: 28.03.2014 JP 2014068728; 30.10.2014 JP 2014220991
(43) Date of publication of application: 30.09.2015
(73) Proprietor: Toto Ltd., Kitakyushu-shi, Fukuoka 802-8601 (JP)
(72) Inventor: Amano, Kazuki, Kitakyushu-shi, Fukuoka 802-8601 (JP); Ide, Takayuki, Kitakyushu-shi, Fukuoka 802-8601 (JP); Shimada, Shogo, Kitakyushu-shi, Fukuoka 802-8601 (JP)
(74) Representative: Takeuchi, Maya

(56) References cited:
- JP-A- 2001 261 459
- JP-A- 2007 246 319
- JP-A- 2011 530 820
- US-A1- 2005 255 335
- US-A1- 2012 018 074

## Description

### BACKGROUND OF THE INVENTION

### (1) Field of the Invention

Embodiments of the present invention relate generally to a reaction sintered silicon carbide member.

### (2) Description of Related Art

A reaction sintered silicon carbide member is low in specific gravity and high in Young's modulus, that is, high in specific rigidity (the ratio of Young's modulus/specific gravity). Thus, the reaction sintered silicon carbide member makes use of the property to be usable for various articles. An example of the articles is a member for a semiconductor exposure apparatus. Hereinafter, a description will be made, as an example, about a measuring structure which surrounds optical elements of an extreme ultraviolet lithographic apparatus (EUV (extreme ultraviolet) exposure apparatus), and housings thereof. In EUV exposure apparatuses, optical elements reflect EUV light, whereby a substrate is exposed to light (see JP 2011-530820 A and JP 2010-171031 A).

The optical device (EUV exposure apparatus) has, as the optical elements, optical elements capable of transmitting beams, and further has at least one partial housing extended from the front surface of at least one of the optical elements to a direction along which one of the beams is radiated out from the optical element, or a direction along which the beam is radiated into the optical element (JP 2011-530820 A).

In this case, the partial housing is entirely or at least partially surrounded by a measuring structure (sensor frame) separated mechanically, or mechanically and thermally from the housing (JP 2011-530820 A). A position sensor and/or a measuring system is/are fixed to this measuring structure (sensor frame) with certainty in such a manner that the sensor and/or the system, and this structure are dynamically stabilized together with a non-actuated mirror; and is/are further fixed with certainty to a basis frame of a system (JP 2011-530820 A). It depends on the stability of the measuring structure whether or not the optical elements are retained at a precise position (JP 2011-530820 A).

Because of the dependency of the retention of the optical elements at a precise position onto the stability of the measuring structure (sensor frame), the measuring structure is desired to have high-performance mechanical properties and thermal properties. The optical elements are arranged to have a complicated positional relationship therebetween. It is therefore expected with ease that the measuring structure (sensor frame) has a complicated shape. Additionally, the size of exposure apparatuses (such as ArF immersion exposure apparatuses) that have been spreading at present is at a level of several meters; thus, it is expected that the size of EUV exposure apparatuses becomes more than one meter and, as a result, so does their measuring structure (their sensor frame). For the raw material of the measuring structure, a light construction material is suitable which has high rigidity and shows a small thermal expansion coefficient and a good thermal conductivity, and, in particular, a fine ceramic material is suitable therefor (JP 2011-530820 A). However, according to conventional methods for producing a fine ceramic material, it is difficult to produce a large-sized structure of one-meter level having a complicated shape US2005 255 335 A1 discloses a reaction sintered silicon carbide member according to the preamble of claim 1.

### SUMMARY OF THE INVENTION

The present invention has been made on the basis of the recognition of such problems, and an object thereof is to provide a reaction sintered silicon carbide member making it possible to produce a large-sized ceramic member having a complicated shape, or to restrain the generation of particles from the member.

A first embodiment of the present invention is a reaction sintered silicon carbide member, characterized by including: a first member made of reaction sintered silicon carbide; a second member made of reaction sintered silicon carbide and having a first face, a second face at a side of the second member that is opposite to the first face side thereof, and a first end face connected to the first and second faces; and a joining portion which joins the first and second members to each other, the joining portion having an intermediate region which joins the first member and the first end face to each other, and is made of reaction sintered silicon carbide, and a first region which joins the first member, the first face and the intermediate region to one another, and is made of reaction sintered silicon carbide.

With this reaction sintered silicon carbide member, the first and second members are certainly joined to each other, and further the silicon carbide member is increased in washability by its corner shape so that the generation of particles therefrom is restrained (wash remnants and others at its corner portion are decreased). The corner portion is improved in cleanability (such as particle-blowing-away property). Consequently, at the time of the silicon carbide member assembling, the generation of particles is restrained.

A second embodiment of the present invention is the reaction sintered silicon carbide member according to the first embodiment, wherein the first region has a first surface different from a surface of the first region that contacts the first member and the first face, and the first surface is inclined with respect to the first face.

With this reaction sintered silicon carbide member, the first and second members are certainly joined to each other, and further the silicon carbide member is increased in washability by its corner shape so that the generation of particles therefrom is restrained (wash remnants and others at its corner portion are decreased). The corner portion is improved in cleanability (such as particle-blowing-away property). Consequently, at the time of the first-and-second-member fabrication, the generation of particles is restrained.

A third embodiment of the present invention is the reaction sintered silicon carbide member according to the second embodiment, wherein the first surface is in a concave form.

With this reaction sintered silicon carbide member, the first and second members are certainly joined to each other, and further the silicon carbide member is increased in washability by its corner shape so that the generation of particles therefrom is restrained (wash remnants and others at its corner portion are decreased). The corner portion is improved in cleanability (such as particle-blowing-away property). Consequently, at the time of the first-and-second-member fabrication, the generation of particles is restrained.

A fourth embodiment of the present invention is the reaction sintered silicon carbide member according to the third embodiment, wherein the angle between the first surface and the first face increases as the distance between the first surface and the first face increases.

With this reaction sintered silicon carbide member, the first and second members are certainly joined to each other, and further the silicon carbide member is increased in washability by its corner shape so that the generation of particles therefrom is restrained (wash remnants and others at its corner portion are decreased). The corner portion is improved in cleanability (such as particle-blowing-away property). Consequently, at the time of the first-and-second-member fabrication, the generation of particles is restrained.

A fifth embodiment of the present invention is the reaction sintered silicon carbide member according to the third embodiment, wherein the angle between the first surface and the first face increases step by step as the distance between the first surface and the first face increases.

With this reaction sintered silicon carbide member, the first and second members are certainly joined to each other, and further the silicon carbide member is increased in washability by its corner shape so that the generation of particles therefrom is restrained (wash remnants and others at its corner portion are decreased). The corner portion is improved in cleanability (such as particle-blowing-away property). Consequently, at the time of the first-and-second-member fabrication, the generation of particles is restrained.

A sixth embodiment of the present invention is the reaction sintered silicon carbide member according to any one of the first to fifth embodiments, wherein the joining portion further has a second region which joins the first member, the second face and the intermediate region to one another, and is made of reaction sintered silicon carbide.

With this reaction sintered silicon carbide member, the first and second members are certainly joined to each other, and further the silicon carbide member is increased in washability by its corner shape so that the generation of particles therefrom is restrained (wash remnants and others at its corner portion are decreased). The corner portion is improved in cleanability (such as particle-blowing-away property). Consequently, at the time of the first-and-second-member fabrication, the generation of particles is restrained.

A seventh embodiment of the present invention is the reaction sintered silicon carbide member according to any one of the first to sixth embodiments, wherein the second member has a first side face connected to the first face, the second face, and the first end face, and the joining portion further has a third region which joins the first member, the first side face and the intermediate region to one another, and is made of reaction sintered silicon carbide.

With this reaction sintered silicon carbide member, the first and second members are certainly joined to each other, and further the silicon carbide member is increased in washability by its corner shape so that the generation of particles therefrom is restrained (wash remnants and others at its corner portion are decreased). The corner portion is improved in cleanability (such as particle-blowing-away property). Consequently, at the time of the first-and-second-member fabrication, the generation of particles is restrained.

An eighth embodiment of the present invention is the reaction sintered silicon carbide member according to any one of second to seventh embodiments, wherein the second member has a corner portion located between the first face and the first end face, and the curvature radius of the first surface is equal to or larger than that of the corner portion.

With this reaction sintered silicon carbide member, the setup of the second curvature radius prevents member-chipping resulting from a pressure given for the joining to restrain the generation of a shortage in the joining strength or in joining precision, which is caused by chips generated by the chipping. The corner portion is improved in cleanability (such as particle-blowing-away property). As a result, at the time of the first-and-second-member fabrication, the generation of particles is restrained.

A ninth embodiment of the present invention is the reaction sintered silicon carbide member according to the eighth embodiment, wherein the curvature radius of the corner portion is more than 0 mm and 1 mm or less.

With this reaction sintered silicon carbide member, the setup of the second curvature radius prevents member-chipping resulting from a pressure given for the joining to restrain the generation of a shortage in the joining strength or in joining precision, which is caused by chips generated by the chipping. The corner portion is improved in cleanability (such as particle-blowing-away property). As a result, at the time of the first-and-second-member fabrication, the generation of particles is restrained.

A tenth embodiment of the present invention is the reaction sintered silicon carbide member according to any one of the first to ninth embodiments, wherein the curvature radius of the first surface is 1 mm or more and 10 mm or less.

With this reaction sintered silicon carbide member, the first and second members are certainly joined to each other, and further the silicon carbide member is increased in washability by its corner shape so that the generation of particles therefrom is restrained (wash remnants and others at its corner portion are decreased). The corner portion is improved in cleanability (such as particle-blowing-away property). Consequently, at the time of the first-and-second-member fabrication, the generation of particles is restrained.

An eleventh embodiment of the present invention is the reaction sintered silicon carbide member according to any one of the second to tenth embodiments, wherein the ratio of the shortest distance from a position where a flat plane containing the first face and the first member cross each other to the first surface to the distance between the first member and the first end face is 0.1 or more and 50 or less.

With this reaction sintered silicon carbide member, the first and second members are certainly joined to each other, and further the silicon carbide member is increased in washability by its corner shape so that the generation of particles therefrom is restrained (wash remnants and others at its corner portion are decreased). The corner portion is improved in cleanability (such as particle-blowing-away property). Consequently, at the time of the first-and-second-member fabrication, the generation of particles is restrained.

A twelfth embodiment of the present invention is the reaction sintered silicon carbide member according to any one of the first to eleventh embodiments, wherein the ratio of the curvature radius of the first surface to the thickness of the second member is 0.1 or more and 1 or less.

With this reaction sintered silicon carbide member, the first and second members are certainly joined to each other, and further the silicon carbide member is increased in washability by its corner shape so that the generation of particles therefrom is restrained (wash remnants and others at its corner portion are decreased). The corner portion is improved in cleanability (such as particle-blowing-away property). Consequently, at the time of the first-and-second-member fabrication, the generation of particles is restrained.

A thirteenth embodiment of the present invention is the reaction sintered silicon carbide member according to any one of the first to twelfth embodiments, wherein the distance between the first and second members is 0.1 mm or more and 1 mm or less.

With this reaction sintered silicon carbide member, the first and second members are certainly joined to each other, and further the silicon carbide member is increased in washability by its corner shape so that the generation of particles therefrom is restrained (wash remnants and others at its corner portion are decreased). The corner portion is improved in cleanability (such as particle-blowing-away property). Consequently, at the time of the first-and-second-member fabrication, the generation of particles is restrained.

A fourteenth embodiment of the present invention is the reaction sintered silicon carbide member according to any one of the first to thirteenth embodiments, wherein the concentration of free silicon in the first region is higher than that in the first member.

With this reaction sintered silicon carbide member, the first and second members are certainly joined to each other, and further the silicon carbide member is increased in washability by its corner shape so that the generation of particles therefrom is restrained (wash remnants and others at its corner portion are decreased). The corner portion is improved in cleanability (such as particle-blowing-away property). Consequently, at the time of the first-and-second-member fabrication, the generation of particles is restrained.

A fifteenth embodiment of the present invention is the reaction sintered silicon carbide member according to any one of the first to thirteenth embodiments, wherein the concentration of free silicon in the first region is higher than that in the intermediate region.

With this reaction sintered silicon carbide member, the first and second members are certainly joined to each other, and further the silicon carbide member is increased in washability by its corner shape so that the generation of particles therefrom is restrained (wash remnants and others at its corner portion are decreased). The corner portion is improved in cleanability (such as particle-blowing-away property). Consequently, at the time of the first-and-second-member fabrication, the generation of particles is restrained.

A sixteenth embodiment of the present invention is the reaction sintered silicon carbide member according to any one of the first to fifteenth embodiments, wherein the surface roughness of a first main surface of the first member that is opposite to the second member is smaller than that of the first surface.

The reaction sintered silicon carbide member is improved in platability, or any other coat-paintability.

A seventeenth embodiment of the present invention is the reaction sintered silicon carbide member according to any one of the first to sixteenth embodiments, wherein the first and second members each have a length more than 1 m, and the first and second members each have a complicated shape.

This reaction sintered silicon carbide member makes it possible to produce a large and complicated shape.

An eighteenth embodiment of the present invention is the reaction sintered silicon carbide member according to any one of the first to seventeenth embodiments, which is used for an EUV exposure apparatus.

This reaction sintered silicon carbide member makes it possible to produce a large and complicated shape.

A nineteenth embodiment of the present invention is the reaction sintered silicon carbide member according to any one of the first to seventeenth embodiments, which is used for a measuring support of an EUV exposure apparatus.

This reaction sintered silicon carbide member makes it possible to produce a large and complicated shape.

### BRIEF DESCRIPTION OF THE DRAWINGS

Fig. 1A and Fig. 1B are schematic views illustrating a reaction sintered silicon carbide member according to an embodiment;
Fig. 2A and Fig. 2B are each a microscopic image of an example of the reaction sintered silicon carbide member;
Fig. 3A is a schematic view of an example of the reaction sintered silicon carbide member, and Figs. 3B to 3E are each a microscopic image of the example;
Fig. 4A is a schematic view of an example of the reaction sintered silicon carbide member, and Figs. 4B to 4D are each a microscopic image of the example;
Fig. 5A is a schematic view of an example of the reaction sintered silicon carbide member, and Figs. 5B to 5D are each a microscopic image of the example;
Fig. 6A is a schematic view of an example of the reaction sintered silicon carbide member, and Figs. 6B to 6D are each a microscopic image of the example;
Figs. 7A to 7C are each a microscopic image of an example of the reaction sintered silicon carbide member;
Fig. 8A is a schematic view of an example of the reaction sintered silicon carbide member, and Fig. 8B is a microscopic image of the example;
Figs. 9A to 9C are schematic views illustrating, respectively, examples of a reaction sintered silicon carbide member according to an embodiment;
Figs. 10A to 10C are schematic sectional views illustrating, respectively, examples of a reaction sintered silicon carbide member according to an embodiment;
Fig. 11 is a schematic sectional view illustrating a reaction sintered silicon carbide member according to an embodiment;
Fig. 12 is a schematic sectional view illustrating a reaction sintered silicon carbide member according to an embodiment;
Fig. 13 is a schematic sectional view illustrating a reaction sintered silicon carbide member according to an embodiment;
Figs. 14A and 14B are each a schematic sectional view illustrating a reaction sintered silicon carbide member according to an embodiment;
Fig. 15 is a schematic sectional view of a reaction sintered silicon carbide member according to an embodiment;
Fig. 16A is a schematic perspective view illustrating a reaction sintered silicon carbide member according to an embodiment, and Fig. 16B is a graph showing a property of the reaction sintered silicon carbide member according to this embodiment;
Fig. 17A is a schematic perspective view illustrating a reaction sintered silicon carbide member according to an embodiment, and Fig. 17B is a table showing a property of the reaction sintered silicon carbide member according to this embodiment;
Fig. 18A is a schematic plan view illustrating a reaction sintered silicon carbide member according to an embodiment, and Figs. 18B and 18C are each a graph showing a property of the reaction sintered silicon carbide member according to this embodiment;
Fig. 19 is a flowchart illustrating a method for producing a reaction sintered silicon carbide member; and
Figs. 20A to 20C are each a schematic perspective view illustrating an example of the reaction sintered silicon carbide member.

### DETAILED DESCRIPTION OF PREFERRED EMBODIMENTS

Hereinafter, individual embodiments of the present invention will be described with reference to the drawings.

The drawings are each a schematic or conceptual diagram, and thus a relationship between the thickness and the width of each of elements or portions therein, the ratio by size between the elements or portions, and others are not necessarily equal to those of the corresponding actual members or parts. Moreover, even when two or more of the drawings illustrate the same element or portion, dimensions or reduced scales of the element or portion may be different from one another between the drawings.

In each of the drawings, about any element equivalent to an already-described element in already-referred-to one out of the drawings, the same reference sign or number as attached to the latter element is attached to the former element; and a detailed description thereon may be appropriately omitted in the specification.

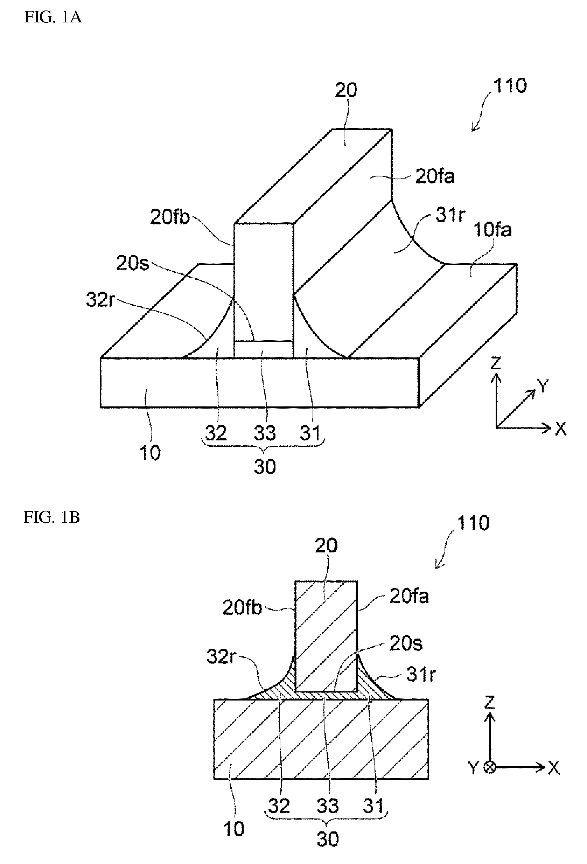

Fig. 1A and Fig. 1B are schematic views illustrating a reaction sintered silicon carbide member according to one of the embodiments to be described.

Specifically, Fig. 1A is a schematic perspective view of the reaction sintered silicon carbide member according to the present embodiment. Fig. 1B is a schematic sectional view of the member in Fig. 1A.

As illustrated in Fig. 1A, in the reaction sintered silicon carbide member, which is a member 110, a first member 10, a second member 20, and a joining portion 30 are located. The first member 10 and the second member 20 are made of reaction sintered silicon carbide (reaction sintered SiC). The first member 10 has a first main face 10fa. The second member 20 has a first face 20fa, a second face 20fb, and a first end face 20s.
The second face 20fb is a face at a side of the second member 20 that is opposite to the first face 20fa side thereof. The first end face 20s is connected to the first face 20fa and the second face 20fb. In this example, the first end face 20s is substantially parallel to the first main face 10fa. In the embodiment, the first end face 20s may be at least partially inclined with respect to the first main face 10fa.

The direction from the first member 10 toward the second member 20 is called the Z axis direction. A direction perpendicular to the Z axis direction is called the X axis direction. A direction perpendicular to the Z and X axis directions is called the Y axis direction.

In this example, the first main face 10fa of the first member 10 is parallel to the X-Y plane. In this example, the first face 20fa and the second face 20fb are parallel to the Y-Z plane.

The joining portion 30 includes an intermediate region 33 (for example, a linking region), a first region 31 (for example, a fillet portion), and a second region 32 (for example, another fillet portion). The intermediate region 33, the first region 31 and the second region 32 are made of reaction sintered silicon carbide. For example, the same reaction sintered silicon carbide as used for the first member 10 and the second member 20 is used for the intermediate region 33, the first region 31 and the second region 32. This manner improves the reaction sintered silicon carbide member 110 in strength.

The intermediate region 33 joins the first member 10 and the first end face 20s to each other. The first region 31 joins the first member 10, the first face 20fa and the intermediate region 33 to one another. The first region 31 has a face contacting the first member 10 and the first face 20fa, and a face (first surface 31r) different form this face. The first surface 31r contacts neither the first member 10 nor the first face 20fa. The second region 32 joins the first member 10, the second face 20fb, and the intermediate region 33 to one another. The second region 32 has a face contacting the first member 10 and the second face 20fb, and a face (second surface 32r) different from this face. The second surface 32r contacts neither the first member 10 nor the second face 20fb.

With this reaction sintered silicon carbide member, the first and second members are certainly joined to each other, and further the silicon carbide member is increased in washability by its corner shape so that the generation of particles therefrom is restrained (wash remnants and others at its corner portion are decreased). The corner portions are improved in cleanability (such as particle-blowing-away property). Consequently, at the time of the first-and-second-member fabrication, the generation of particles is restrained.

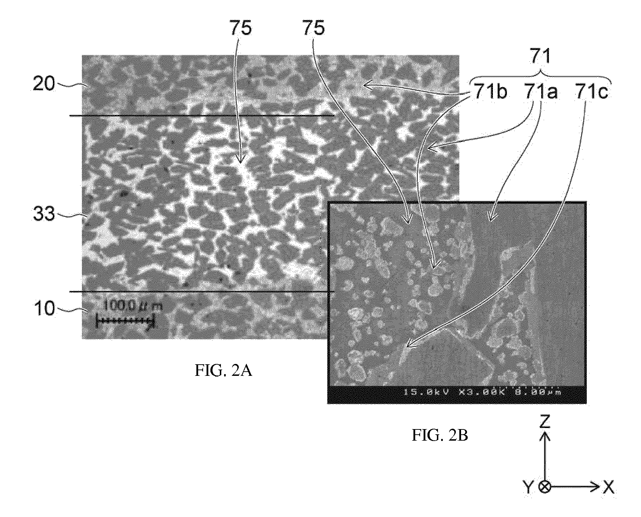

Fig. 2A and Fig. 2B are microscopic images of the reaction sintered silicon carbide member.

Specifically, Fig. 2A is an optical microscopic image thereof, and Fig. 2B is an electron microscopic image as obtained by enlarging the image in Fig. 2A partially.

The optical microscopic image shown in Fig. 2A shows the reaction sintered silicon carbide member (its first member 10, second member 20 and intermediate region 33). In the reaction sintered silicon carbide member, there are first SiC particles 71a (coarse particle raw material), second SiC particles 71b (fine particle raw material), reaction sintered SiC 71c and a Si metal 75 (free silicon). The reaction sintered SiC 71c is produced around the SiC particles to have a thickness of about 100 nanometers (nm).

In the intermediate region 33 (joining layer), the quantity of the Si metal 75 is larger than that in the first member 10 (joining portion) and the second member 20 (joining portion). The microstructure of the Si metal 75 is continuous into a network form. This manner makes the intermediate region 33 dense.

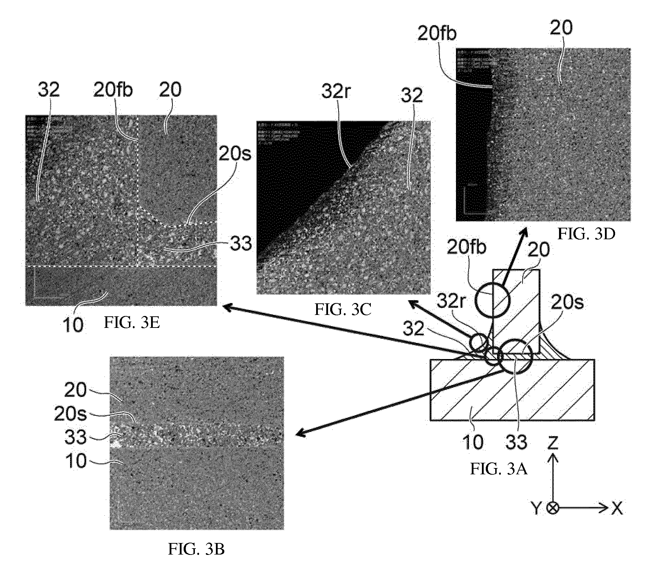

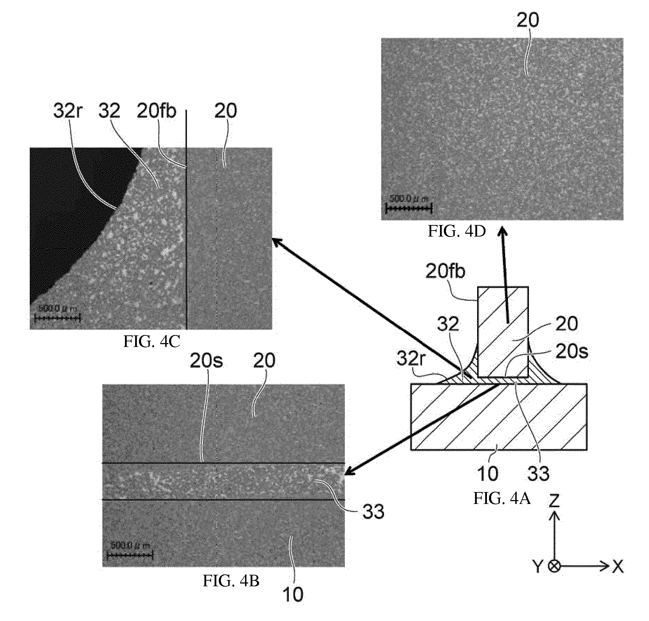

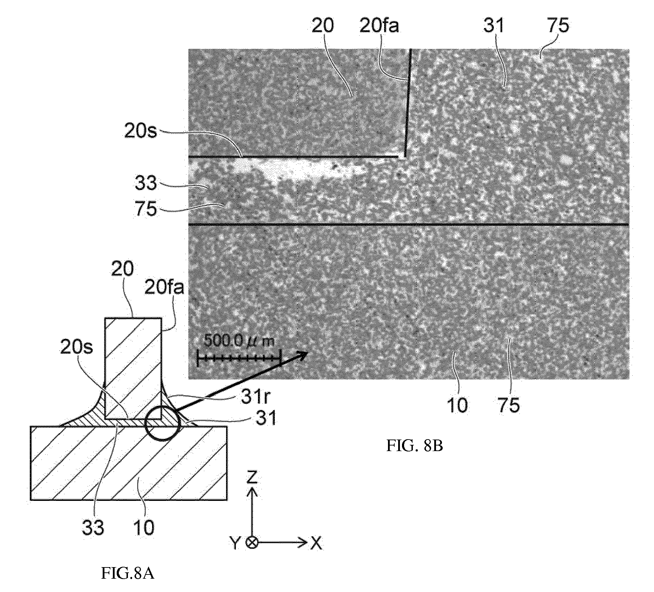

Figs. 3A to 3E are each a schematic view or a microscopic image of an example of the reaction sintered silicon carbide member, as well as Figs. 4A to 4D, Figs. 5A to 5D, Figs. 6A to 6D, Figs. 7A to 7C, and Figs. 8A and 8B.

Specifically, Figs. 3B, 3C, 3D and 3E are each a laser microscopic image of the corresponding example of the reaction sintered silicon carbide member.

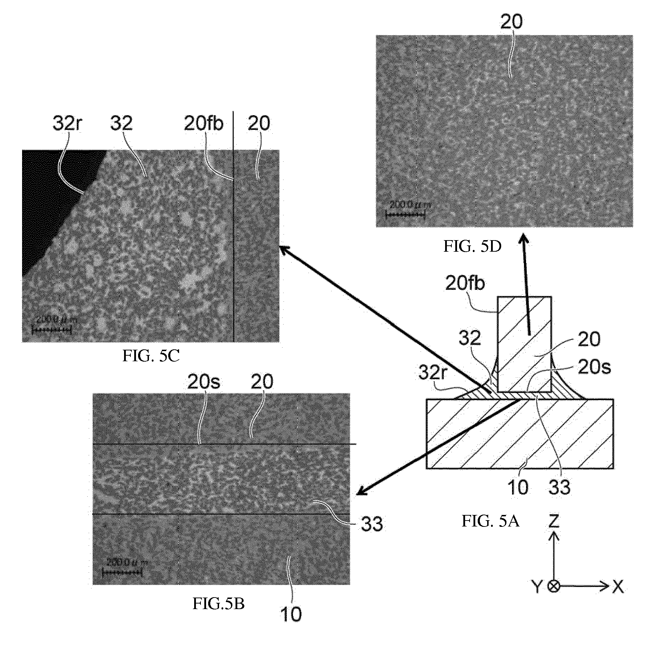

Figs. 4B to 4D are respective optical microscopic images of the corresponding example, which are different from each other in magnifying power, as well as Figs. 5B to 5D, Figs. 6B to 6D, Figs. 7A to 7C, and Fig. 8B. Positions corresponding to the respective optical microscopic images are illustrated in schematic views of Fig. 3A, as well as Fig. 4A, Fig. 5A, Fig. 6A, and Fig. 8A.

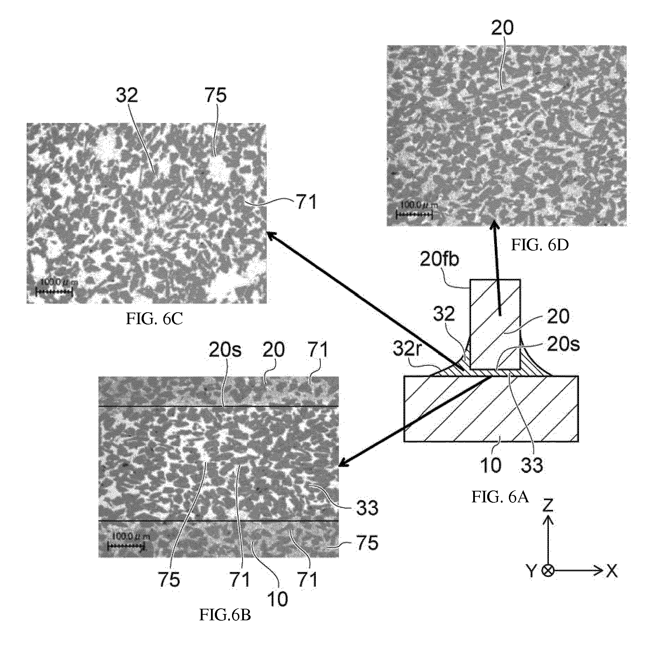

As is understood from Figs. 6B and 6C, the quantity of a Si metal 75 contained in a second region 32 is larger than that of the Si metal 75 contained in each of a first member 10 and a second member 20. In other words, the concentration of free Si (Si metal 75) in a second region 32 is higher than that of the free Si (Si metal 75) in each of the first member 10 and the second member 20. The quantity of the Si metal 75 contained in the second region 32 is larger than that of the Si metal 75 contained in an intermediate region 33. In other words, the concentration of the free Si (Si metal 75) in the second region 32 is higher than that of the free silicon (Si metal 75) in the intermediate region 33. These matters will be described again later, together with an example of a method for measuring the concentration of free Si.

As is understood from Figs. 6B and 6C, the orientation ratio of silicon carbide 71 in the intermediate region 33 is higher than that of the silicon carbide 71 in the second region 32. As is understood from Fig. 6B, the orientation ratio of the silicon carbide 71 in the intermediate region 33 is higher than that of the silicon carbide 71 in the first member 10.

Hereinafter, a description will be made about an example of a method for measuring the concentration of free Si.

Initially, a laser microscope is used to take respective photographs of images of the front surface of a sample. In this example, a laser microscope is a confocal laser microscope, OLS 4100, manufactured by Shimadzu Corp. The scope from which each of the photographs is taken (observed scope) is a scope of 250 µm x 250 µm in area. The magnifying power is a power of 1000 magnifications.

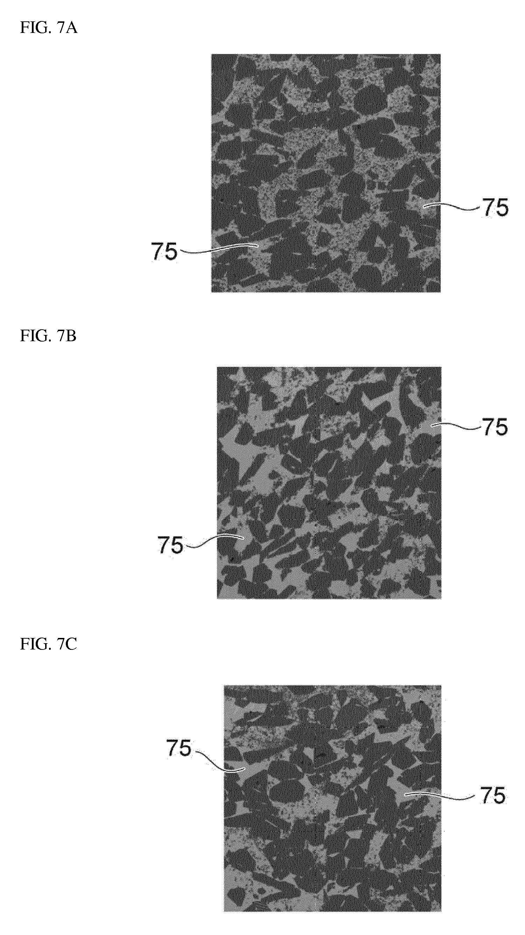

Figs. 7A to 7C referred to above are examples of photographed images. Specifically, Fig. 7A is an enlarged image of a first member 10, Fig. 7B is an enlarged image of a first region 31, and Fig. 7C is an enlarged image of an intermediate region 33.

As shown in Figs. 7A to 7C, the photographed images are each, for example, a monochrome image. In each of the photographed images, free Si (Si metal 75) is higher in brightness than the other portions. Accordingly, the photographed image is subjected to image analysis, whereby high brightness portions are separable as free Si portions from the other portions.

Next, each of the photographed images is subjected to image analysis. In this example, software, WinROOF (ver. 6. 5. 1), manufactured by MITANI CORPORATION is used therefor. The image analysis using the software WinROOF is made, for example, as follows: the photographed monochrome image is separated into free silicon portions and the other portions by automatic binarization (valley method). Commands of the software WinROOF are then carried out to calculate the proportion by area of the free silicon portions in the area of the visual field.

According to this processing, the concentration of the free silicon is gained in each of the first member 10, the first region 31, and the intermediate region 33.

About each of the first member 10, the first region 31, and the intermediate region 33, the concentration of the free silicon in each of plural spots thereof was gained, and then the gained individual concentrations were averaged. As a result, the concentration of the free silicon was 26.2% in the first member 10, 28.6% in the first region 31, and 27.2% in the inteimediate region 33.

As described just above, the concentration of the free silicon in the first region 31 (as well as the second region 32) is higher than that in the first member 10 (as well as the second member 20).

Moreover, the concentration of the free silicon in the first region 31 (as well as the second region 32) is higher than that of the free silicon in the intermediate region 33.

A preferred range of the concentration of the free silicon is as follows: the concentration of the free silicon in the first member 10 (as well as the second member 20) is preferably 18% or more and 34% or less; that of the free silicon in the first region 31 (as well as the second region 32), preferably from 20% or more and 36% or less; and that of the free silicon in the intermediate region 33, preferably from 19% or more and 35% or less.

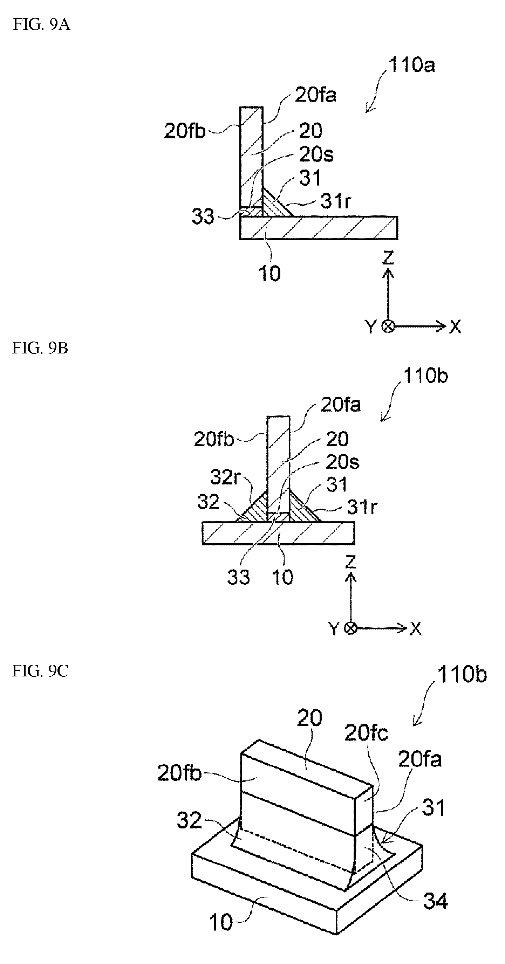

Figs. 9A to 9C are schematic views illustrating, respectively, examples of a reaction sintered silicon carbide member according to one of the embodiments to be described.

As illustrated in Fig. 9A, in one of the examples, which is a reaction sintered silicon carbide member 110a, a first region 31 and an intermediate region 33 are located in a joining portion 30.

As illustrated in Fig. 9B, in another of the examples, which is a reaction sintered silicon carbide member 110b, a first surface 31r of a first region 31 is inclined with respect to, for example, a first face 20fa of a second member 20. A second surface 32r of a second region 32 is inclined with respect to a second face 20fb of the second member 20.

As illustrated in Fig. 9C, a joining portion 30 further has a third region 34. The third region 34 contacts a side face of a second member 20, and a first member 10. In other words, the second member 20 further has a first side face 20fc. The first side face 20fc is connected to a first face 20fa, a second face 20fb, and a first end face 20s. The third region 34 joins the first member 10, the first side face 20fc, and an intermediate region 33 to one another. The third region 34 includes reaction sintered silicon carbide. For the third region 34, for example, the same structure and material as used in the first region 31 may be supplied.

With the reaction sintered silicon carbide member of this embodiment, the first and second members are certainly joined to each other, and further the silicon carbide member is increased in washability by its corner shape so that the generation of particles therefrom is restrained (wash remnants and others at its corner portion are decreased). The corner portion is improved in cleanability (such as particle-blowing-away property). Consequently, at the time of the first-and-second-member fabrication, the generation of particles is restrained.

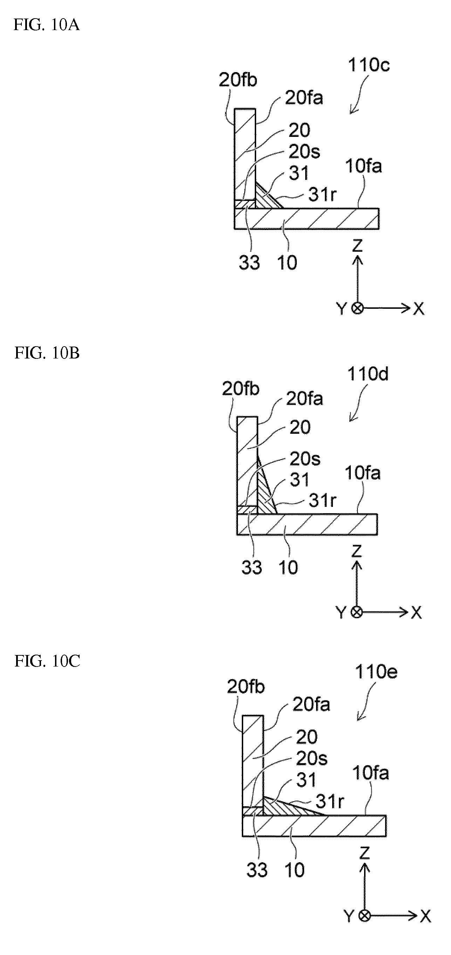

Figs. 10A to 10C are schematic sectional views illustrating, respectively, examples of a reaction sintered silicon carbide member according to one of the embodiments.

As illustrated in Fig. 10A, in one of these examples, which is a reaction sintered silicon carbide member 110c, the length in the Z axis direction of a first region 31 is equivalent to that in the X axis direction of the first region 31.

As illustrated in Fig. 10B, in another of the examples, which is a reaction sintered silicon carbide member 110d, the length in the Z axis direction of a first region 31 is larger than that in the X axis direction of the first region 31.

As illustrated in Fig. 10C, in still another of the examples, which is a reaction sintered silicon carbide member 110e, the length in the Z axis direction of a first region 31 is smaller than that in the X axis direction of the first region 31.

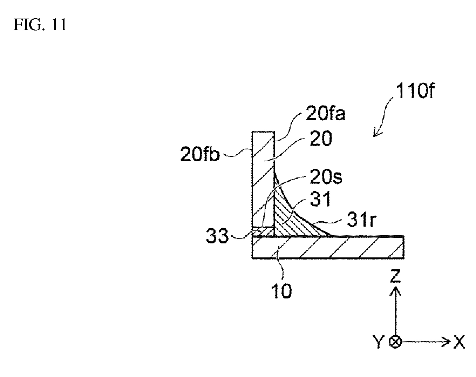

Fig. 11 is a schematic sectional view illustrating a reaction sintered silicon carbide member according to one of the embodiments.

As illustrated in Fig. 11, in the reaction sintered silicon carbide member, which is a member 110f, a first surface 31r of a first region 31 is a concave curved surface.

With this reaction sintered silicon carbide member, its first and second members are certainly joined to each other, and further the silicon carbide member is increased in washability by its corner shape so that the generation of particles therefrom is restrained (wash remnants and others at its corner portion are decreased). The corner portion is improved in cleanability (such as particle-blowing-away property). Consequently, at the time of the first-and-second-member fabrication, the generation of particles is restrained.

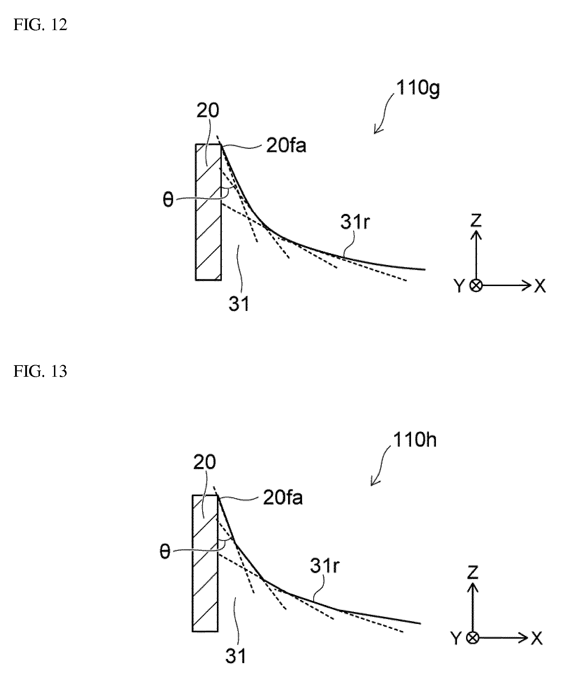

Fig. 12 is a schematic sectional view illustrating a reaction sintered silicon carbide member according to one of the embodiments.

As illustrated in Fig. 12, in the reaction sintered silicon carbide member, which is a member 110g, the angle θ between a first surface 31r and a first face 20fa increases as the distance between the first surface 31a and the first face 20fa increases.

Fig. 13 is a schematic sectional view illustrating a reaction sintered silicon carbide member according to one of the embodiments.

As illustrated in Fig. 13, in the reaction sintered silicon carbide member, which is a member 110h, the angle θ between a first surface 31r and a first face 20fa changes step by step.

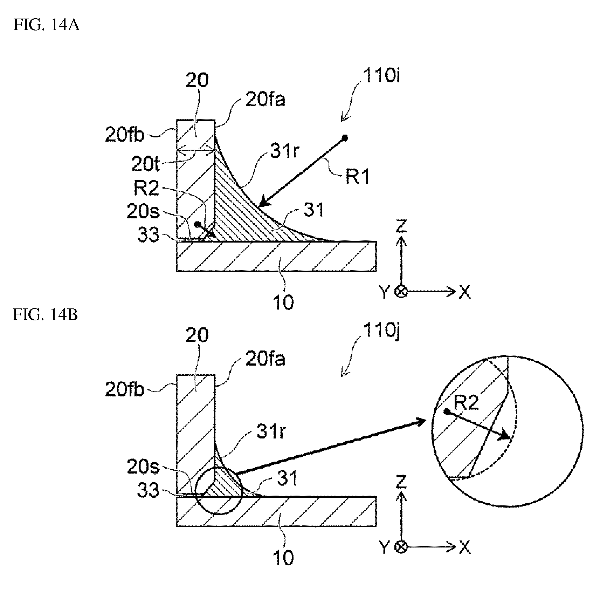

Figs. 14A and 14B are each a schematic sectional view illustrating a reaction sintered silicon carbide member according to one of the embodiments.

As illustrated in Fig. 14A, the curvature radius of a first surface 31r of a first region 31 is called the first curvature radius R1 A second member 20 has a corner portion between a first face 20fa and a first end face 20s. The curvature radius of this corner portion is called the second curvature radius R2.

In the reaction sintered silicon carbide member (member 110i) illustrated in Fig. 14A, the first curvature radius R1 is, for example, equal to or more than the second curvature radius R2. The first curvature radius R1 is, for example, 1 mm or more and 10 mm or less. The first curvature radius R1 is preferably 3 mm or more and 5 mm or less. The second curvature radius R2 is, for example, more than 0 mm and is 1 mm or less. The second curvature radius R2 is preferably 0.2 mm or more and 0.5 mm or less. If the second curvature radius R2 is more than 1 mm, for example, an intermediate region 33 is lowered in joining strength. If the second curvature radius R2 is excessively long, the corner portion of the second member 20 is not easily formed with good precision.

With this reaction sintered silicon carbide member, the setup of the second curvature radius prevents member-chipping resulting from a pressure given for the joining to restrain the generation of a shortage in the joining strength or in joining precision, which is caused by chips generated by the chipping. The corner portion is improved in cleanability (such as particle-blowing-away property). As a result, at the time of the first-and-second-member fabrication, the generation of particles is restrained.

In the reaction sintered silicon carbide member 110i, for example, the setup of the second curvature radius R2 can prevent member-chipping resulting from the pressure given for the joining to restrain, for example, the generation of a shortage in the joining strength or in joining precision, which is caused by chips generated by the chipping.

In the second member 20, the distance from the first face 20fa to a second face 20fb is defined as the second member thickness 20t of the second member 20. The ratio of the curvature radius R1 to the second member thickness 20t is, for example, 0.1 . or more and 1 or less.

As illustrated in Fig. 14B, in the reaction sintered silicon carbide member, which is a member 110j, a corner portion is located between a first face 20fa of a second member 20 and a first end face 20s. The corner portion may be a chamfered plane. At this time, the angle of the corner portion to a plane containing the first end face 20s is about 45 degrees. When the corner portion is, for example, a chamfered plane, the radius of a circle passing through both ends of the corner portion may be used as the second curvature radius R2. At this time, this second curvature radius R2 may satisfy the above-mentioned requirements.

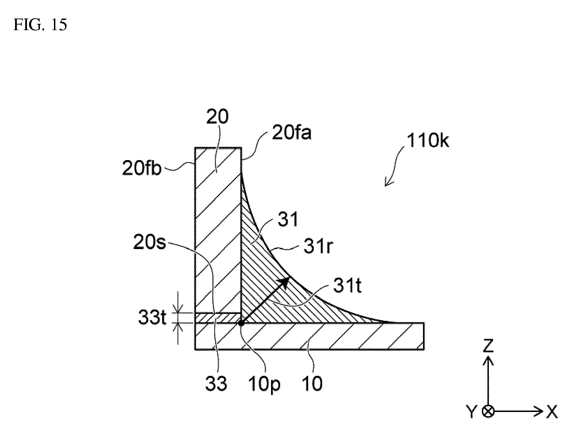

Fig. 15 is a schematic sectional view of a reaction sintered silicon carbide member according to one of the embodiments.

As illustrated in Fig. 15, the distance between a first member 10 and a first end face 20s is defined as the intermediate region thickness 33t of an intermediate region 33. A point where a plane containing a first face 20fa and the first member 10 cross each other is defined as a first reference point 10p. The shortest distance from the first reference point 10p to a first surface 31r is defined as the first region thickness 31t of a first region 31.

In the reaction sintered silicon carbide member (member 110k) illustrated in Fig. 15, the intermediate region thickness 33t is, for example, 0.1 mm or more and 1 mm or less. The ratio of the first region thickness 31t to the intermediate region thickness 33t is, for example, 0.1 or more and 50 or less. If the ratio of the first region thickness 31t to the intermediate region thickness 33t is less than 0.1, for example, the strength of the intermediate region 33 is lowered. If the ratio of the first region thickness 31t to the intermediate region thickness 33t is more than 50, for example, the first region 31 is easily cracked or damaged into some other form.

With this reaction sintered silicon carbide member, the first and second members are certainly joined to each other, and further a corner shape high in washability is easily produced. This matter increases the silicon carbide member in washability so that the generation of particles therefrom is restrained (wash remnants and others at the corner portion are decreased). The corner portion is improved in cleanability (such as particle-blowing-away property). Consequently, at the time of the first-and-second-member fabrication, the generation of particles is restrained.

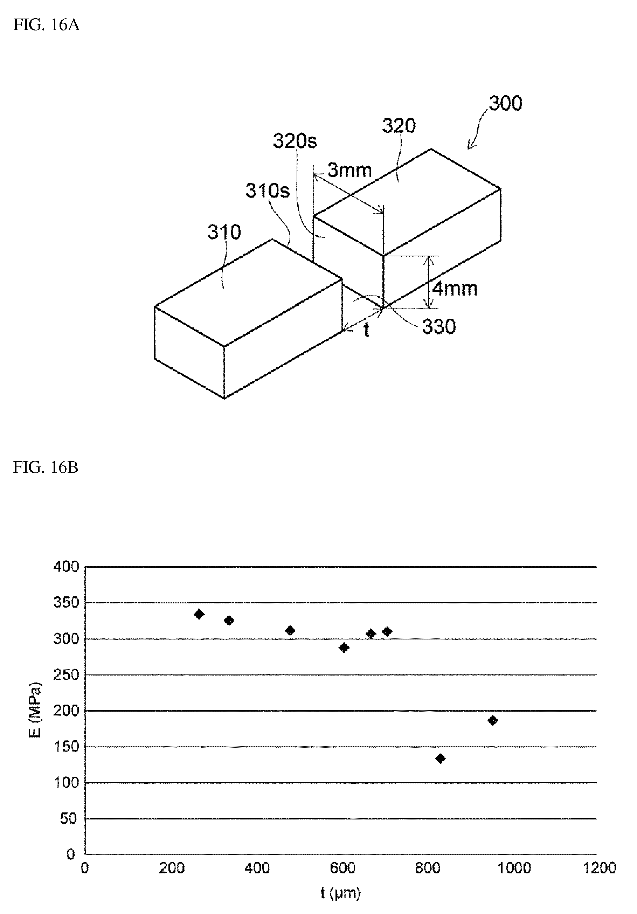

Fig. 16A is a schematic perspective view illustrating a reaction sintered silicon carbide member according to one of the embodiments. Fig. 16B is a graph showing a property of the reaction sintered silicon carbide member according to this embodiment.

Specifically, Figs. 16A and 16B show experimental results about the strength of the reaction sintered silicon carbide member. Fig. 16A is a schematic view illustrating a specimen therefor. Fig. 16B is a graph showing the property of the reaction sintered silicon carbide member.

As illustrated in Fig. 16A, this reaction sintered silicon carbide member specimen, which is a specimen 300, has a member 310, a member 320, and a joining portion 330. The member 310 has a member end face 310s. The member 320 has a member end face 320s. The joining portion 330 joins the member end faces 310s and 320s to each other. The distance between the member end faces 310s and 320s (the thickness t of the joining portion 330) is called the thickness t.

About the specimen 300, the three-point bending strength (JIS R 1601) thereof is measured. In the measurement of the three-point bending strength, a load is applied to the specimen in such a manner that the load is applied to be centered upon the joining portion 330, and then the three-point bending strength of the specimen 300 is measured. In this experiment, the thickness t of the joining portion 330 is varied.

In Fig. 16B, its transverse axis represents the thickness t. Its vertical axis represents the three-point bending strength E. When the thickness t is 200 µm or more and less than 800 µm, the strength E is high. When the thickness t becomes 800 µm or more, the strength E is abruptly lowered.

The thickness t is, for example, desirably 0.1 mm or more and 1 mm or less, more desirably 0.2 mm or more and 0.7 mm or less. A binder-based layer is formed on the joining portion 330 between the member end faces 310s and 320s. The thickness of the binder-based layer of the joining portion 330 is at least 0.1 mm; thus, in the reaction sintered silicon carbide member, a thickness t less than 0.1 mm is not easily produced. If the thickness t of the joining portion 330 is more than 1 mm, pores or gaps are generated in the joining portion 330 in accordance with a shrinkage behavior (such as drying shrinkage, hardening shrinkage or firing shrinkage) of the binder (adhesive) for forming the joining portion 330. This matter lowers the strength and reliability of the reaction sintered silicon carbide.

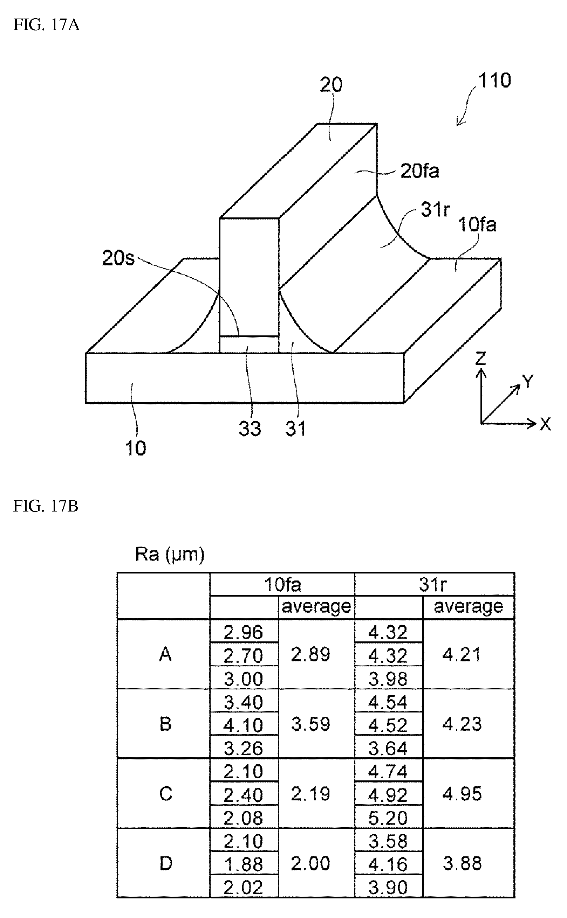

Fig. 17A is a schematic perspective view illustrating a reaction sintered silicon carbide member according to one of the embodiments. Fig. 17B is a table showing a property of the reaction sintered silicon carbide member according to this embodiment.

Specifically, Figs. 17A and 17B show measurement results about the surface roughness of the member, and Fig. 17B is a table showing respective surface roughnesses of specimens of the reaction sintered silicon carbide member. Fig. 17A shows positions where the individual surface roughnesses Ra shown in Fig. 17B are measured.

As shown in Fig. 17B, the surface roughness Ra of a first main surface 10fa is smaller than that Ra of a first surface 31r.

The reaction sintered silicon carbide member is improved in platability, or any other coat-paintability.

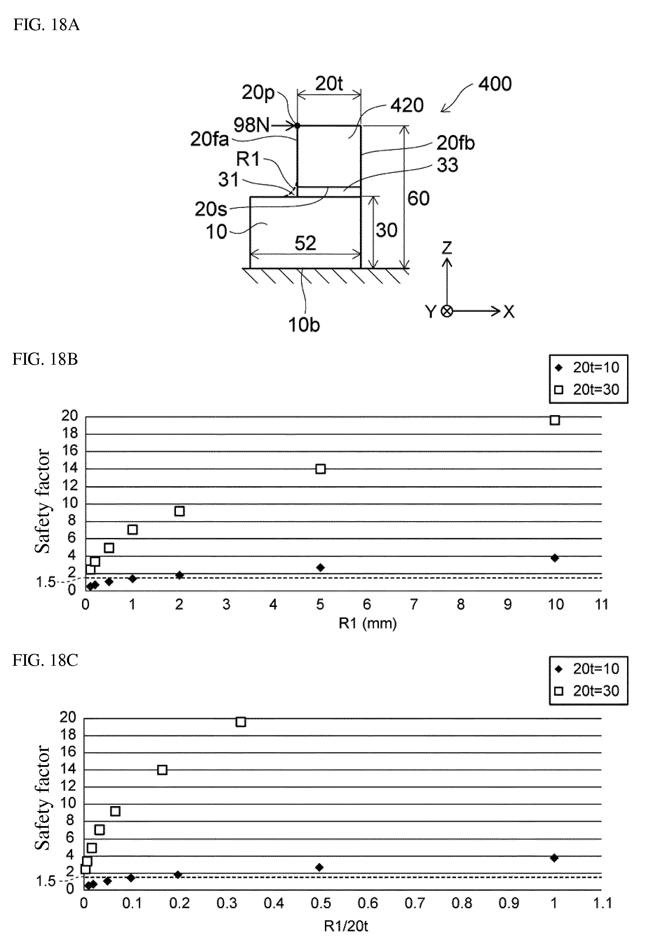

Fig. 18A is a schematic plan view illustrating a reaction sintered silicon carbide member according to one of the embodiments. Figs. 18B and 18C are each a graph showing a property of the reaction sintered silicon carbide member according to this embodiment.

Specifically, Figs. 18A to 18C show experimental results about the stress (bending stress) of the reaction sintered silicon carbide member when the curvature radius (first curvature radius R1) of a first surface 31r of a first region 31 is varied.

Figs. 18B and 18C are each a graph showing the property of the reaction sintered silicon carbide member.

In the bending stress measurement, in the state that a first member 10 is completely restricted, a load of 98 N is applied to a corner portion 20p of a second member 20 into a minus Z axis direction.

In Fig. 18B, its transverse axis represents the first curvature radius R1, and its vertical axis is the safety factor of specimens. As shown in Fig. 18B, when the first curvature radius R1 is 1 mm or more, the safety factor is larger than 1.5.

In Fig. 18C, its transverse axis represents the ratio of the first curvature radius R1 to the second member thickness 20t (R1/20t). Its vertical axis represents the safety factor of specimens. As shown in Fig. 18C, when the ratio of the first curvature radius R1 to the second member thickness 20t (R1/20t) is 0.1 or more, the safety factor is larger than 1.5.

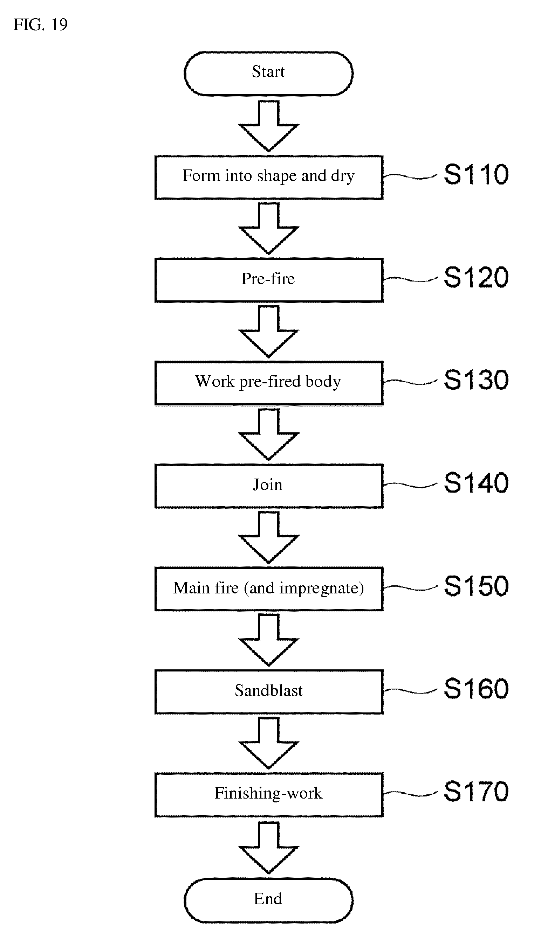

Fig. 19 is a flowchart illustrating a method for producing a reaction sintered silicon carbide member.

In step S110, raw materials of a reaction sintered silicon carbide member are formed into the predetermined shape and dried.

In step S120, the formed and dried reaction sintered silicon carbide member precursors are pre-fired. In the pre-firing, a binder and other impurities contained in the reaction sintered silicon carbide member precursors are removed. This way prevents the oxidization of Si to be contained in the reaction sintered silicon carbide member precursors at the time of main firing that will be described later, and other inconveniences.

In step S130, the pre-fired reaction sintered silicon carbide member precursors, i.e., the pre-fired bodies are worked.

In step S140, the worked pre-fired bodies are joined to each other. The joining attains not only Si join between the first and second members, but also Si join of any complicated moiety that is unable to be formed to be integrated with the first and second members.

In step S150, the resultant joined body is subjected to main firing (with impregnation). In the main firing (with impregnation), the joined body is impregnated with Si at a temperature of 1400°C or more and 1800°C or less in a vacuum, so as to be reaction-sintered. Simultaneously, the joining is also finished.

In step S160, the main-fired (and Si-impregnated) body is subjected to sandblasting. By the sandblasting, Si adhering onto the surface of this main-fired body is removed.

In step S170, the main-fired body subjected to the sandblasting is subjected to finishing work. In the finishing work, the main-fired body is shaved to be finally finished from the viewpoint of precision. In this way, a reaction sintered silicon carbide member is produced.

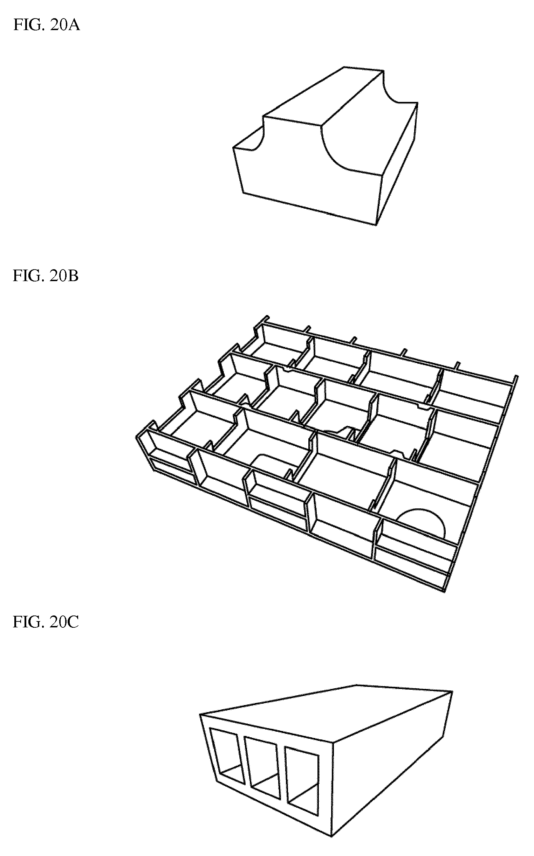

Figs. 20A to 20C are each a schematic perspective view illustrating an example of the reaction sintered silicon carbide member.

As illustrated in Fig. 20A, the reaction sintered silicon carbide member is, for example, in a convex form.

As illustrated in Fig. 20B, the reaction sintered silicon carbide member is, for example, an integrally formed body having a complicated shape. In this case, dimensions of the whole thereof are as follows: the width is 320 mm; the length, 250 mm; the height, 30 mm; and the rib thickness, 3 mm.

As illustrated in Fig. 20C, the reaction sintered silicon carbide member is, for example, a joined article produced by reaction sintering joining.

The reaction sintered silicon carbide member according to any one of the embodiments is applicable to, for example, an exposure apparatus (for example, a measuring support of an EUV exposure apparatus).

With the reaction sintered silicon carbide member, the first and second members are certainly joined to each other, and further the silicon carbide member is increased in washability by its corner shape so that the generation of particles therefrom is restrained (wash remnants and others at its corner portion are decreased). The corner portion is improved in cleanability (such as particle-blowing-away property). Consequently, at the time of the silicon carbide member assembling, the generation of particles is restrained.

With this reaction sintered silicon carbide member, a large and complicated shape can be produced.

A reaction sintered silicon carbide member according to additional one of the embodiments to be described is a ceramic composite member having a structure in which ceramic members are joined to each other through a linking portion. A fillet portion is fitted to a joining portion between the ceramic members. The number of ceramic members constituting the ceramic composite member is not limited to two, and may be three or more. The ceramic members are each a reaction sintered silicon carbide member. In the first and second ceramic members, the same reaction sintered silicon carbide member as used for the linking portion and the fillet portion is used. This matter improves the ceramic composite member in strength.

The linking portion and the fillet portion each have a basic microstructure in which a free Si phase is continuously present into a network form in gaps between SiC particles. The ceramic composite member can be further improved in strength by incorporating fine SiC particles into the Si phase.

The linking portion and the fillet portion can be obtained by subjecting an adhesive moiety containing at least silicon carbide powder and a resin to thermal treatment (thermal treatment for decomposing the resin thermally to be made carbonaceous), impregnating the moiety with melted silicon (Si), and then reaction-sintering the resultant. The adhesive layer may contain carbon powder.

### [Particles and Strength]

The SiC particles are not limited. However, JP 2011-530820A states that when SiC particles become large, the microstructure becomes inhomogeneous or the free Si regions become large to lower the whole in strength. One of the members in which the finer particles are used is higher in strength. It is therefore more preferred that the SiC particles are smaller. Furthermore, the following manner is selectable: a manner of blending coarse particles and fine particles with each other to raise the packing density of the SiC particles, thereby making the free Si phase small to improve the strength.

### [Si phase and Strength]

The free Si phase is present to have a network structure in gaps between the SiC particles. It is important that the free Si phase has a continuous network structure.

JP 2011-530820 A discloses as follows: a dense joining portion can be obtained by causing a free Si phase to be present in gaps between SiC particles. Furthermore, it is preferred that the linking portion has a porosity of 5% or less. If the porosity of the linking portion is more than 5%, the strength of the linking portion is largely varied; consequently, the strength of the ceramic member 1 is also largely varied. JP 2011-530820A also discloses that the average diameter of particles of the free Si phase is small, and the free Si phase is finely and homogeneously distributed, thereby making it possible to heighten the reaction-sintered-ceramic member in strength with good reproducibility.

The joining portion in the present invention is made of a binder containing a resin. The proportion of the resin is essentially 5% by volume or more, and is preferably 20% by volume or more to cause the binder to keep a shape after the joining. Thus, the joining portion is shrunken and carbonized in the heating step up to the impregnation with Si, so that voids in the joining portion become large. This matter causes the joining portion to contain, in the structure thereof, Si in a larger proportion than the ceramic members. In the same manner as the joining portion, the fillet portion also contains, in the structure thereof, Si in a larger proportion than the ceramic members. It is easily assumed also from JP 2011-530820A that these structures make the joining portion lower in strength than the fired body obtained by impregnating the ceramic members with Si. The fillet portion compensates for the joining strength of the joining portion to improve the reaction sintered silicon carbide member in strength and reliability.

### [Joining portion thickness]

The average thickness of the linking portion is preferably set into a range of 0.1 mm or more and 1 mm or less, more preferably 0.2 mm or more and 0.7 mm or less. A binder-based layer is formed on the interface between the ceramic members, and the joining portion at the joining time. It is therefore difficult from the viewpoint of the production process to produce the joining portion with a thickness less than 0.1 mm. If the average thickness of the linking portion is more than 1 mm, pores or gaps are generated in the interface between the linking portion and the ceramic members, or are generated inside the joining portion in accordance with a shrinkage behavior (such as drying shrinkage, hardening shrinkage or firing shrinkage) of the binder (adhesive) formed in the joining portion. This matter lowers the interface or the inside in strength to lower the ceramic composite member in strength and reliability.

### [Joining portion structure]

It is preferred that the joining portion has a homogeneous microstructure. The particle composition constituting the joining portion is preferably the same particle composition as constituting the ceramic members. It is assumed that this particle composition makes the particle packing proportion of the ceramic members close to that of the joining portion around/in the interface therebetween, so that these members are improved in adhesiveness to be improved in joining strength before the firing and in that after the firing with the Si impregnation. In this way, the ceramic composite member can be improved in reliability and strength. Furthermore, when the fillet portion is formed to have the same homogenous microstructure as the joining portion and the same particle composition as the ceramic members, the ceramic composite member can be further improved in reliability and strength.

### [Joining portion strength]

The ceramic composite member of this embodiment is formed by approximating the microstructure of the joining portion for joining the ceramic members to each other to that of the ceramic members. Specifically, a control is made about the average particle diameter and the blend ratio of the SiC particles constituting the joining portion. When a carbon material is added, the average particle diameter and the blend ratio are controlled. Furthermore, a further control is made about the resin amount and the solvent amount at the joining time, thereby making it possible to heighten the joining portion in strength reliability. The joining portion has a three-point bending strength of 150 to 400 MPa and a large proportion of contained Si to have slightly lower strength properties than the ceramic members. The three-point bending strength of the joining portion is a value obtained by measuring the ceramic composite member in such a manner that a load is applied to be centered upon the joining portion.

### [Usage]

The ceramic composite member is applicable to device components or device members, for example, semiconductor-related components such as a tool for semiconductor-producing apparatuses, a heat sink and a dummy wafer, high-temperature structural members, mechanical sealing members, braking members, sliding components, mirror components, pump components, and heat exchanger components. The ceramic composite member is suitably usable, particularly, for any device component or member from which dust is required to be rarely or slightly generated in a high vacuum.

### [Production method]

Hereinafter, a method for producing the ceramic member of the present invention will be described. In order to produce the ceramic composite member of the present invention, its first and second members are joined to each other at a stage when at least one of these members is a shaped body, pre-fired body or reaction sintered body containing silicon carbide powder and carbon powder. Specifically, two or more ceramic bodies to be joined to each other are prepared. These ceramic bodies to be joined may each be a shaped body obtained by slip casting of using a dispersing agent to disperse silicon carbide and carbon in a solvent such as water, thereby yielding a slurry, adding a binder to the slurry, casting the resultant slurry into a plaster mold; or a pre-fired body obtained by pre-firing this shaped body in an inert atmosphere or a vacuum. The shaped body is not limited to any cast body, and may be a shaped body obtained by making a slurry composition as described above into the form of grains, and then subjecting the grains to mechanical press or CIP forming. A pre-fired body of such a shaped body is usable. The method for shaping the silicon carbide and carbon powders is not particularly limited, and may be extrusion forming, injection molding, gel cast forming, or some other.

Even when bonding surfaces of the ceramic bodies to be joined are non-worked surfaces, no problem is caused. However, it is preferred, for heightening the reliability of the join, to work the bonding surfaces to be rendered flat surfaces. In order to make the surfaces higher in adhesion strength, it is more preferred to make the surfaces larger in roughness. The increase in the surface roughness makes it possible to heighten the adhesiveness between a joining portion formed by impregnation with melted Si and the ceramic bodies to be joined, so as to heighten these members in joining strength.

Next, the ceramic bodies to be joined are bonded to each other through an adhesive containing silicon carbide powder and a resin. After the bonding, the same adhesive is used to form a fillet portion. The binder may contain carbon powder. The respective particle diameters of the silicon carbide and carbon powders, and the blend ratio therebetween are preferably those based on the same formulation conditions as used to produce the ceramic bodies to be joined. It is assumed that this manner makes the microstructures around the interfaces close to each other to improve the ceramic bodies to be joined in adhesion strength. From the viewpoint of the production process, the binder is preferably painted to be spread. The binder may be diluted with, for example, a solvent to be adjusted into an arbitrary viscosity. The solvent for adjusting the viscosity is not limited, and may be selected at will from water, alcohols, and others. The binder is present as a binder layer between the ceramic bodies to be joined, and is further present in the fillet portion. The resin which is to be an adhesive component in the binder is preferably a thermosetting resin such as phenolic resin, furan resin, epoxy resin or polyimide resin.

The silicon carbide powder incorporated into the binder preferably has an average particle diameter of 0.1 to 100 µm. If the average particle diameter of the silicon carbide powder is less than 0.1 µm, the powder-dispersed state easily becomes uneven so that the distribution state of the SiC particles or the phase of free Si becomes uneven. If the average particle diameter of the silicon carbide powder is more than 100 µm, the free Si phase becomes large in size so that the joining portion 4 may not be made sufficiently high in strength.

The carbon powder has an average particle diameter of 0.01 to 20 µm. If the average particle diameter of the carbon powder is less than 0.01 µm, particles of the powder easily aggregate so that the formulation of the binder becomes unstable. Furthermore, in the joining portion 4, the distribution state of the SiC particles or the free Si phase becomes unstable. In the present invention, join or adhesion high in reliability is attained by dispersing fine carbon powder having a particle diameter of 0.01 to 0.08 µm into a high dispersion level. When the average particle diameter of carbon powder is more than 20 µm, the following are caused according to JP 2011-530820A: a choking phenomenon is easily caused, so that the joining portion may be lowered in strength; and further the average particle diameter of the free Si phase increases so that the linking portion is lowered or varied in strength. Thus, it is assumed that unfavorable situations are caused.

The binder preferably contains the silicon carbide powder in a proportion of 50 to 95% by mass of the total of the silicon carbide powder and carbon components originating from the carbon powder and the resin. The proportion by weight of the carbon components originating from the carbon powder and the resin to the silicon carbide powder (C/SiC) is preferably set to 20% by weight or less. It is not necessarily essential to add the carbon powder as a raw material. However, it is preferred that the carbon component is present. Even when no carbon powder is added, carbon is present in a slight amount because of the presence of the carbon components produced by the carbonization of the resin. When the proportion of the carbon components is more than 20% by weight, the following is assumed: carbon reacts with Si to be converted to SiC, and volume expansion generated at this reaction time affects the resultant so that the resultant may not exhibit a sufficient strength. After the ceramic bodies are joined to each other through the binder described hereinbefore, the fillet portion is formed.

Next, the joined ceramic bodies, the binder layer and the fillet portion are thermally treated to be carbonized into a porous region. In other words, the resin is thermally decomposed to be made carbonaceous; this matter, together with the production of pores at the time of drying after the joining, makes the joined ceramic bodies and the others porous. The porous region functions as a Si-penetrating region. The thermal treatment for making the binder layer porous is preferably conducted at a temperature of 300 to 2000°C in a vacuum or an inert gas atmosphere.

The porosity of the porous region is selectable from the range of porosities usable in ordinary reaction sintered bodies. The porosity is preferably more than 20% in order to ensure paths through which melted Si is supplied. Unless the Si-supplying paths are ensured, the joining portion comes to have a structure in which the remaining carbon quantity is increased. If the porosity of the porous region is more than 80%, the free Si phase quantity is increased. These forms each cause a decline in the strength of the joining portion. Next, the porous body of the joined ceramic bodies, the joining portion and the fillet portion is heated to a temperature of the melting point of Si, or higher. This heated porous body is impregnated with melted Si. Specifically, for example, the porous body is heated to 1400°C or higher in a vacuum or an inert atmosphere to be impregnated with melted Si. By the impregnation with melted Si, the porous body is subjected to reaction sintering to form a ceramic joined body having the joining portion. The heating step for attaining the porous form may be performed simultaneously with the impregnating step; specifically, through the step of raising the temperature up to 1400°C, the resin is carbonized to yield a porous body, and the heating/temperature-raising operation is continued as it is to attain reaction sintering, whereby a ceramic joined body can be yielded.

The carbon components originating from the resin present in the porous region, and the carbon powder contact melted Si at high temperature so that a reaction is caused therebetween. As a result, silicon carbide is produced. The silicon carbide powder as one of the starting materials hardly changes. However, a structure is produced in which the silicon carbide powder as the starting material is coated with a SiC component produced by the reaction sintering of a part of this powder. When carbon itself is turned to SiC, SiC is formed into particles having a small particle diameter. Furthermore, in gaps between these SiC particles, Si is present as free Si to be continuous into a network form.

By the use of a joining process as described above, a joined body is yielded which has two or more ceramic bodies and has a joining portion and a fillet portion made of reaction sintered silicon carbide.

### Examples

Prepared were two SiC materials, one of which was a SiC coarse particle material having an average particle diameter of 20 to 100 µm, and the other of which was a SiC fine particle material having an average particle diameter of 0.1 to 1 µm. These were mixed with each other into a high-density packing form. For the high-density packing, a basic blend ratio of the fine particles to the coarse particles was 3/7, and on the basis of this blend ratio, actual blended amounts of the two were decided by adjusting conditions for selecting the respective particle diameters of the starting materials. Carbon powder was prepared in a proportion of 5 to 15% by weight of the total of the SiC raw materials. To water were added a dispersing agent, the prepared SiC powders, and the carbon powder, and a ball mill was used to mix these components together. To the mixture was added an acrylic binder in a proportion of 1 to 10% by weight of the mixture. The resultant was subjected to defoaming treatment to be used as a slip casting material. This material was slip-cast to yield formed bodies. The resultant formed bodies were each taken out from the slip casting mold, and then dried. In this slip casting, the water content in the slip casting material was adjusted to make the material into a viscosity permitting the material to flow into the mold. The defoaming step was assisted by optional addition of a defoaming agent. The resultant formed bodies were pre-fired in a temperature range of 1600 to 2000°C to yield ceramic bodies to be joined. Respective joining surfaces of the bodies were subjected to mechanical working and others as required to form final joining surfaces. About the ceramic bodies to be joined, not only the pre-fired bodies, but also the dried bodies after the shape-formation or reaction sintered bodies are usable. The ceramic bodies to be joined were prepared in a required number. An operation for removing working rubbish and cutting remnants was applied to the final joining surfaces.

A binder was prepared, using the same raw materials and blend ratio as used for the above-mentioned SiC powder and carbon powder. Thereto were added a solvent and a dispersing agent, and these components were mixed with each other to be made into a slurry. Thereto was added a defoaming agent as required. A surfactant may be optionally added thereto in a proportion of several percent to promote improvement of the interface in wettability. The mixing step may be a step using any one of various mixing methods or means, such as propeller stirring, a ball mill, and centrifugal mixing. An epoxy resin was added in a proportion of 5 to 30% to the slurry, in which the components were mixed. When the solvent was water, the selected resin was of an emulsion type, which is high in affinity with water. The resin-added binder was sufficiently stirred, and then subjected to defoaming treatment. The binder was prepared while the water content therein was adjusted in order for the binder to have a viscosity suitable for joining operation and fillet-forming operation.

The resultant binder was painted to the surface of a joining position of one body of any pair of the beforehand-prepared ceramic bodies to be joined, and then a joining position of the other body was pushed onto the binder-painted surface to join the paired bodies to each other. In order to adjust the joining layer thickness in accordance with the pushing pressure, the pressure was increased to produce a required thickness although the joining pressure is not limited. The joining portion thickness is adjustable in accordance with the viscosity of the binder as well as the pushing pressure; and a thinner joining portion can be formed as the viscosity is lower while a thicker joining portion can be formed as the viscosity is higher. In order to produce the required joining portion thickness, conditions for individual joining portion thicknesses to be produced were beforehand found out from the viscosity and the pushing pressure, and then conditions necessary for the required joining portion thickness were selected. In this way, a joining portion was formed.

The formed joining portion was dried, and subjected to resin-setting treatment, and then a fillet portion was formed. Specifically, for the formation of the fillet portion, the same binder as used at the joining time was used, and the binder was painted into a necessary amount onto a fillet-forming portion to form a shape required for the fillet portion by aid of a spatula or some other. The resultant fillet portion-attached joined member was dried, and subjected to resin-setting treatment.

The sufficiently hardened joined member was heated to 300°C or higher in an inert atmosphere to be carbonized, and then pre-fired at 1700°C in a vacuum. The joined member was then subjected to Si-impregnating treatment in a temperature range of 1400 to 1800°C to be converted to a reaction sintered SiC member. Surplus Si adhering onto the surface thereof was removed by sandblasting or mechanical work.

The above-mentioned embodiments make it possible to produce a large-sized ceramic member having a complicated shape, and provide a reaction sintered silicon carbide member which restrains the generation of particles therefrom.

In the present specification, the words "perpendicular" and "parallel" have not only meanings of being strictly perpendicular and being strictly parallel, respectively, but also meanings of being perpendicular and being parallel, respectively, the degree of being perpendicular and being parallel having a variation or the like that is dependent on the production process. In short, it is sufficient for any perpendicular or parallel two to be substantially perpendicular or parallel to each other.

The above has described embodiments of the present invention, referring to specific examples thereof. However, the present invention is not limited to these specific embodiments nor examples. For example, as far as a reaction sintered silicon carbide member can be realized and the realized member can produce advantageous effects equivalently to the reaction sintered silicon carbide member of the present invention by selecting, from a known scope, appropriately one or more out of members, joining portions and other elements for the realized member by those skilled in the art, the realized member is included in the scope of the present invention.

As far as a technique obtained by combining two or more elements from the individual specific embodiments or examples with each other in a technically attainable scope includes the subject matter of the present invention, the technique is included in the scope of the present invention.

As far as any reaction sintered silicon carbide member obtained by making an appropriate modification or design change on the basis of the above-mentioned reaction sintered silicon carbide members described as embodiments of the present invention includes the subject matter of the present invention, this silicon carbide member is also included in the scope of the present invention.

Additionally, those skilled in the art can arrive at various changed examples or modified examples within the scope of the conception of the present invention. It should be understood that these changed examples or modified examples belong to the scope of the present invention.

Several embodiments of the present invention have been described. However, these embodiments are presented as mere examples, not to intend any restriction of the scope of the invention. These novel embodiments may be carried out in various forms, and various omissions, replacements, and/or changes may be applied to the embodiments as far as the resultant modifications do not depart from the subject matter of the invention. These embodiments and the modifications are included in the scope of the invention recited in the claims.

## Claims

1. A reaction sintered silicon carbide member, **characterized by** comprising:
a first member (10) comprising reaction sintered silicon carbide;
a second member (20) comprising reaction sintered silicon carbide and having a first face (20fa), a second face (20fb) at a side of the second member (20) that is opposite to the first face (20fa) side thereof, and a first end face (20s) connected to the first and second faces (20fa) and (20fb); and
a joining portion (30) which joins the first and second members (10) and (20) to each other, **characterised in that** the joining portion (30) comprises an intermediate region (33) which joins the first member (10) and the first end face (20s) to each other and comprises reaction sintered silicon carbide, and a first region (31) which joins the first member (10), the first face (20fa) and the intermediate region (33) to one another and comprises reaction sintered silicon carbide.

2. The reaction sintered silicon carbide member according to claim 1, wherein the first region (31) has a first surface (31r) different from a surface of the first region (31) that contacts the first member (10) and the first face (20fa), and
the first surface (31r) is inclined with respect to the first face (20fa).

3. The reaction sintered silicon carbide member according to claim 2, wherein the first surface (31r) is in a concave form.

4. The reaction sintered silicon carbide member according to claim 3, wherein the angle between the first surface (31r) and the first face (20fa) increases as the distance between the first surface (31r) and the first face (20fa) increases.

5. The reaction sintered silicon carbide member according to claim 3, wherein the angle between the first surface (31r) and the first face (20fa) increases step by step as the distance between the first surface (31r) and the first face (20fa) increases.

6. The reaction sintered silicon carbide member according to any one of claims 1 to 5, wherein the joining portion (30) further comprises a second region (32) which joins the first member (10), the second face (20fb) and the intermediate region (33) to one another, and comprises reaction sintered silicon carbide.

7. The reaction sintered silicon carbide member according to any one of claims 1 to 6, wherein the second member (20) has a first side face (20fc) connected to the first face (20fa), the second face (20fb), and the first end face (20s), and
the joining portion (30) further comprises a third region (34) which joins the first member (10), the first side face (20fc) and the intermediate region (33) to one another, and comprises reaction sintered silicon carbide.

8. The reaction sintered silicon carbide member according to any one of claims 2 to 7, wherein the second member (20) has a corner portion (20p) located between the first face (20fa) and the first end face (20s), and
the curvature radius of the first surface (31r) is equal to or larger than that of the corner portion (20p).

9. The reaction sintered silicon carbide member according to claim 8, wherein the curvature radius of the corner portion (20p) is more than 0 mm and 1 mm or less.

10. The reaction sintered silicon carbide member according to any one of claims 1 to 9, wherein the curvature radius of the first surface (31r) is 1 mm or more and 10 mm or less.

11. The reaction sintered silicon carbide member according to any one of claims 2 to 10, wherein the ratio of the shortest distance from a position where a flat plane containing the first face (20fa) and the first member (10) cross each other to the first surface (31r) to the distance between the first member (10) and the first end face (20s) is 0.1 or more and 50 or less.

12. The reaction sintered silicon carbide member according to any one of claims 1 to 11, wherein the ratio of the curvature radius of the first surface (31r) to the thickness of the second member (20) is 0.1 or more and 1 or less.

13. The reaction sintered silicon carbide member according to any one of claims 1 to 12, wherein the distance between the first and second members (10) and (20) is 0.1 mm or more and 1 mm or less.

14. The reaction sintered silicon carbide member according to any one of claims 1 to 13, wherein the concentration of free silicon in the first region (31) is higher than that in the first member (10).

15. The reaction sintered silicon carbide member according to any one of claims 1 to 13, wherein the concentration of free silicon in the first region (31) is higher than that in the intermediate region (33).

16. The reaction sintered silicon carbide member according to any one of claims 1 to 15, wherein the surface roughness of a first main surface of the first member (10) that is opposite to the second member (20) is smaller than that of the first surface (31r).

17. The reaction sintered silicon carbide member according to any one of claims 1 to 16, wherein the first and second members (10) and (20) each have a length more than 1 m, and
the first and second members (10) and (20) each have a complicated shape.

18. The reaction sintered silicon carbide member according to any one of claims 1 to 17, which is used for an EUV exposure apparatus.

19. The reaction sintered silicon carbide member according to any one of claims 1 to 17, which is used for a measuring support of an EUV exposure apparatus.

## Patentansprüche

1. Reaktionsgesintertes Siliciumcarbidelement, **dadurch gekennzeichnet, dass** es Folgendes umfasst:
ein erstes Element (10), das reaktionsgesintertes Siliciumcarbid umfasst;
ein zweites Element (20), das reaktionsgesintertes Siliciumcarbid umfasst und
Folgendes aufweist: eine erste Fläche (20fa), eine zweite Fläche (20fb) an einer Seite des zweiten Elements (20), die sich gegenüber der Seite der ersten Fläche (20fa) befindet, und eine erste Stirnfläche (20s), die mit der ersten und zweiten Fläche (20fa) und (20fb) verbunden ist; und
einen Verbindungsabschnitt (30), der das erste und das zweite Element (10) und (20) miteinander verbindet, **dadurch gekennzeichnet, dass** der Verbindungsabschnitt (30) einen Zwischenbereich (33), der das erste Element (10) und die erste Stirnfläche (20s) miteinander verbindet und reaktionsgesintertes Siliciumcarbid umfasst, und einen ersten Bereich (31) umfasst, der das erste Element (10), die erste Fläche (20fa) und den Zwischenbereich (33) miteinander verbindet und reaktionsgesintertes Siliciumcarbid umfasst.

2. Reaktionsgesintertes Siliciumcarbidelement nach Anspruch 1, wobei der erste Bereich (31) eine erste Oberfläche (31r) aufweist, die sich von einer Oberfläche des ersten Bereichs (31) unterscheidet, die das erste Element (31) und die erste Fläche (20fa) berührt, und
wobei die erste Oberfläche (31r) in Bezug auf die erste Fläche (20fa) geneigt ist.

3. Reaktionsgesintertes Siliciumcarbidelement nach Anspruch 2, wobei die erste Oberfläche (31r) in einer konkaven Form vorliegt.

4. Reaktionsgesintertes Siliciumcarbidelement nach Anspruch 3, wobei der Winkel zwischen der ersten Oberfläche (31r) und der ersten Fläche (20fa) mit dem Abstand zwischen der ersten Oberfläche (31r) und der ersten Fläche (20fa) zunimmt.

5. Reaktionsgesintertes Siliciumcarbidelement nach Anspruch 3, wobei der Winkel zwischen der ersten Oberfläche (31r) und der ersten Fläche (20fa) schrittweise mit dem Abstand zwischen der ersten Oberfläche (31r) und der ersten Fläche (20fa) zunimmt.

6. Reaktionsgesintertes Siliciumcarbidelement nach einem der Ansprüche 1 bis 5, wobei der Verbindungsabschnitt (30) überdies einen zweiten Bereich (32) umfasst, der das erste Element (10), die zweite Fläche (20fb) und den Zwischenbereich (33) miteinander verbindet und reaktionsgesintertes Siliciumcarbid umfasst.

7. Reaktionsgesintertes Siliciumcarbidelement nach einem der Ansprüche 1 bis 6, wobei das zweite Element (20) eine ersten Seitenfläche (20fc) aufweist, die mit der ersten Fläche (20fa), der zweiten Fläche (20fb) und der ersten Stirnfläche (20s) verbunden ist, und
wobei der Verbindungsabschnitt (30) überdies einen dritten Bereich (34) umfasst, der das erste Element (10), die erste Seitenfläche (20fc) und den Zwischenbereich (33) miteinander verbindet und reaktionsgesintertes Siliciumcarbid umfasst.

8. Reaktionsgesintertes Siliciumcarbidelement nach einem der Ansprüche 2 bis 7, wobei das zweite Element (20) einen Eckabschnitt (20p) aufweist, der sich zwischen der ersten Fläche (20fa) und der ersten Stirnfläche (20s) befindet, und wobei der Krümmungsradius der ersten Oberfläche (31r) gleich oder größer als der des Eckabschnitts (20p) ist.

9. Reaktionsgesintertes Siliciumcarbidelement nach Anspruch 8, wobei der Krümmungsradius des Eckabschnitts (20p) größer als 0 mm und 1 mm oder weniger ist.

10. Reaktionsgesintertes Siliciumcarbidelement nach einem der Ansprüche 1 bis 9, wobei der Krümmungsradius der ersten Oberfläche (31r) 1 mm oder mehr und 10 mm oder weniger ist.

11. Reaktionsgesintertes Siliciumcarbidelement nach einem der Ansprüche 2 bis 10, wobei das Verhältnis zwischen dem kürzesten Abstand von einer Position, in der eine flache Ebene, die die erste Fläche (20fa) enthält, und das erste Element (10) sich kreuzen, zur ersten Oberfläche (31r) und dem Abstand zwischen dem ersten Element (10) und der ersten Stirnfläche (20s) 0,1 oder mehr und 50 oder weniger ist.

12. Reaktionsgesintertes Siliciumcarbidelement nach einem der Ansprüche 1 bis 11, wobei das Verhältnis zwischen dem Krümmungsradius der ersten Oberfläche (31r) und der Dicke des zweiten Elements (20) 0,1 oder mehr und 1 oder weniger ist.

13. Reaktionsgesintertes Siliciumcarbidelement nach einem der Ansprüche 1 bis 12, wobei der Abstand zwischen dem ersten und zweiten Element (10) und (20) 0,1 mm oder mehr und 1 mm oder weniger ist.

14. Reaktionsgesintertes Siliciumcarbidelement nach einem der Ansprüche 1 bis 13, wobei die Konzentration des freien Siliciums im ersten Bereich (31) höher als die im ersten Element (10) ist.

15. Reaktionsgesintertes Siliciumcarbidelement nach einem der Ansprüche 1 bis 13, wobei die Konzentration des freien Siliciums im ersten Bereich (31) höher als die im Zwischenbereich (33) ist.

16. Reaktionsgesintertes Siliciumcarbidelement nach einem der Ansprüche 1 bis 15, wobei die Oberflächenrauheit einer ersten Hauptoberfläche des ersten Elements (10), die/das sich gegenüber dem zweiten Element (20) befindet, geringer als die der ersten Oberfläche (31r) ist.

17. Reaktionsgesintertes Siliciumcarbidelement nach einem der Ansprüche 1 bis 16, wobei das erste und zweite Element (10) und (20) jeweils eine Länge von mehr als 1 m aufweisen und
wobei das erste und zweite Element (10) und (20) jeweils eine komplizierte Form aufweisen.

18. Reaktionsgesintertes Siliciumcarbidelement nach einem der Ansprüche 1 bis 17, das für eine EUV-Belichtungseinrichtung verwendet wird.

19. Reaktionsgesintertes Siliciumcarbidelement nach einem der Ansprüche 1 bis 17, das für eine Messunterstützung einer EUV-Belichtungseinrichtung verwendet wird.

## Revendications

1. Elément en carbure de silicium lié par réaction, **caractérisé par le fait qu'**il comprend :
un premier élément (10) comprenant du carbure de silicium lié par réaction ;
un second élément (20) comprenant du carbure de silicium lié par réaction et comportant une première face (20fa), une seconde face (20fb) au niveau d'un côté du second élément (20) qui est opposée au côté de la première face (20fa) de celui-ci, et une première face d'extrémité (20s) raccordée aux première et seconde faces (20fa) et (20fb) ; et
une partie de jonction (30) qui relie les premier et second éléments (10) et (20) l'un à l'autre,
**caractérisé en ce que** la partie de jonction (30) comprend une zone intermédiaire (33) qui relie le premier élément (10) et la première face d'extrémité (20s) l'un à l'autre et comprend du carbure de silicium lié par réaction, et une première zone (31) qui relie le premier élément (10), la première face (20fa) et la zone intermédiaire (33) l'un à l'autre et comprend du carbure de silicium lié par réaction.

2. Elément en carbure de silicium lié par réaction selon la revendication 1, dans lequel la première zone (31) présente une première surface (31r) différente d'une surface de la première zone (31) qui vient en contact avec le premier élément (10) et la première face (20fa), et
la première surface (31r) est inclinée par rapport à la première face (20fa).

3. Elément en carbure de silicium lié par réaction selon la revendication 2, dans lequel la première surface (31r) présente une forme concave.

4. Elément en carbure de silicium lié par réaction selon la revendication 3, dans lequel l'angle entre la première surface (31r) et la première face (20fa) augmente à mesure que la distance entre la première surface (31r) et la première face (20fa) augmente.

5. Elément en carbure de silicium lié par réaction selon la revendication 3, dans lequel l'angle entre la première surface (31r) et la première face (20fa) augmente pas à pas, à mesure que la distance entre la première surface (31r) et la première face (20fa) augmente.

6. Elément en carbure de silicium lié par réaction selon l'une quelconque des revendications 1 à 5, dans lequel la partie de jonction (30) comprend, en outre, une seconde zone (32) qui relie le premier élément (10), la seconde face (20fb) et la zone intermédiaire (33) l'un à l'autre et comprend du carbure de silicium lié par réaction.

7. Elément en carbure de silicium lié par réaction selon l'une quelconque des revendications 1 à 6, dans lequel le second élément (20) comporte une première face latérale (20fc) raccordée à la première face (20fa), la seconde face (20fb), et la première face d'extrémité (20s), et
la partie de jonction (30) comprend, en outre, une troisième zone (34) qui relie le premier élément (10), la première face latérale (20fc) et la zone intermédiaire (33) l'un à l'autre, et comprend du carbure de silicium lié par réaction.

8. Elément en carbure de silicium lié par réaction selon l'une quelconque des revendications 2 à 7, dans lequel le second élément (20) comporte une partie d'angle (20p) située entre la première face (20fa) et la première face d'extrémité (20s), et
le rayon de courbure de la première surface (31r) est supérieur ou égal à celui de la partie d'angle (20p).

9. Elément en carbure de silicium lié par réaction selon la revendication 8, dans lequel le rayon de courbure de la partie d'angle (20p) est supérieur à 0 mm et inférieur ou égal à 1 mm.

10. Elément en carbure de silicium lié par réaction selon l'une quelconque des revendications 1 à 9, dans lequel le rayon de courbure de la première surface (31r) est supérieur ou égal à 1 mm et inférieur ou égal à 10 mm.

11. Elément en carbure de silicium lié par réaction selon l'une quelconque des revendications 2 à 10, dans lequel le rapport de la distance la plus courte entre une position à laquelle un plan plat contenant la première face (20fa) et le premier élément (10) se coupent l'un l'autre et la première surface (31r) sur la distance entre le premier élément (10) et la première face d'extrémité (20s) est supérieur ou égal à 0,1 et inférieur ou égal à 50.

12. Elément en carbure de silicium lié par réaction selon l'une quelconque des revendications 1 à 11, dans lequel le rapport du rayon de courbure de la première surface (31r) sur l'épaisseur du second élément (20) est supérieur ou égal à 0,1 et inférieur ou égal à 1.

13. Elément en carbure de silicium lié par réaction selon l'une quelconque des revendications 1 à 12, dans lequel la distance entre les premier et second éléments (10) et (20) est supérieure ou égale à 0,1 mm et inférieure ou égale à 1 mm.

14. Elément en carbure de silicium lié par réaction selon l'une quelconque des revendications 1 à 13, dans lequel la concentration en silicium libre dans la première zone (31) est supérieure à celle dans le premier élément (10).

15. Elément en carbure de silicium lié par réaction selon l'une quelconque des revendications 1 à 13, dans lequel la concentration en silicium libre dans la première zone (31) est supérieure à celle dans la zone intermédiaire (33).

16. Elément en carbure de silicium lié par réaction selon l'une quelconque des revendications 1 à 15, dans lequel la rugosité de surface d'une première surface principale du premier élément (10) qui est opposé au second élément (20) est inférieure à celle de la première surface (31r).

17. Elément en carbure de silicium lié par réaction selon l'une quelconque des revendications 1 à 16, dans lequel les premier et second éléments (10) et (20) présentent chacun une longueur supérieure à 1 m, et
les premier et second éléments (10) et (20) présentent une forme complexe.

18. Elément en carbure de silicium lié par réaction selon l'une quelconque des revendications 1 à 17, qui est utilisé pour un dispositif d'exposition à un rayonnement UV extrême.

19. Elément en carbure de silicium lié par réaction selon l'une quelconque des revendications 1 à 17, qui est utilisé pour un support de mesure d'un dispositif d'exposition à un rayonnement UVE.
